# EUROPEAN PATENT SPECIFICATION

(11) **EP 2 980 811 B1**
(45) Date of publication and mention of the grant of the patent: **23.05.2018**
(21) Application number: 14775132.5
(22) Date of filing: 18.03.2014
(51) Int. Cl.: H01F 1/33, B22F 1/00, B22F 1/02, H01F 1/00, H01F 1/147, H01F 1/26, H05K 9/00, H01F 1/20

(54) **COMPOSITE MAGNETIC POWDER FOR NOISE SUPPRESSING**
KOMPOSITMAGNETPULVER ZUR GERÄUSCHUNTERDRÜCKUNG
POUDRE MAGNÉTIQUE POUR SUPPRESSION DE BRUIT

(30) Priority: 29.03.2013 JP 2013074513
(43) Date of publication of application: 03.02.2016
(73) Proprietor: Powdertech Co., Ltd., Kashiwa-shi, Chiba 277-8557 (JP)
(72) Inventor: AGA, Koji, Kashiwa-shi Chiba 277-8557 (JP); IGARASHI, Tetsuya, Kashiwa-shi Chiba 277-8557 (JP)
(74) Representative: Vossius & Partner Patentanwälte Rechtsanwälte mbB
(86) International application number: PCT/JP2014/057394
(87) International publication number: WO 2014/156848

(56) References cited:
- WO-A1-2005/096325
- JP-A- H11 307 334
- JP-A- 2003 273 568
- JP-A- 2005 120 470
- JP-A- 2006 269 892
- JP-A- 2006 269 892
- JP-A- 2008 258 601
- JP-A- 2008 308 711
- JP-A- 2012 009 797
- US-A1- 2008 220 231
- US-A1- 2010 000 769

## Description

### [Technical Field]

The present invention relates to a composite magnetic powder for noise suppression, particularly to a composite magnetic powder for noise suppression which exhibits low heat generation due to a small dielectric constant loss on the high frequency side and has ability to suppress the noise over a wide range from a low frequency through a high frequency.

### [Background Art]

In digital electronic equipment such as personal computers and cellular phones, magnetic powders for noise suppression or noise suppressors using the same in a sheet form or the like have been conventionally employed in order to prevent the unnecessary electromagnetic waves from leaking to outside or the electromagnetic waves from mutually interfering between circuits within the equipment, or to prevent the equipment from malfunctioning due to the external electromagnetic waves.

In particular, electronic components have been densely mounted due to miniaturization and weight reduction of the digital electronic equipment in recent years. Such highly dense mounting has been more likely to cause electromagnetic faults due to mutual interference of the electromagnetic waves between the components or the circuit substrates.

Furthermore, since operational frequencies of such digital electronic equipment have become increasingly higher and the unnecessary electromagnetic waves generated therefrom have become those of a higher frequency from a band of MHz to a band of GHz, there has been required a magnetic powder for noise suppression or a noise suppressor using the same to cope with these issues.

On the other hand, since heat tends to be accumulated within the equipment and heat radiation is also not readily performed in the highly densely mounted state, a magnetic powder for noise suppression which just simply absorbs the electromagnetic waves and converts the electromagnetic waves to heat or a noise suppressor using the same in the sheet form or the like is not sufficient enough, and there has been required a magnetic powder for noise suppression capable of further suppression of heat generation or a noise suppressor using the same in the sheet form or the like.

A variety of proposals have been conventionally provided in order to cope with such requirements. For example, Patent Literature 1 (Japanese Patent Laid-Open No. 2003-332113) describes a flat soft magnetic powder, of which oxygen content is 1.5% by weight or less, obtained by subjecting a soft magnetic powder to flattening-processing, and a composite magnetic sheet obtained by dispersing the flat soft magnetic powder in a rubber matrix. According to the literature, the flat soft magnetic powder has a high magnetic permeability and excellent performance as an electromagnetic wave absorber. In addition, Patent Literature 2 (Japanese Patent Laid-Open No. 2005-281783) describes a soft magnetic powder for noise suppression which has a flat soft magnetic alloy powder with an aspect ratio from 5 to 100 containing Fe-Si-Al and an oxidized layer on the surface of the alloy powder and exhibits both of the diffraction lines of lattice reflection (002) and lattice reflection (001) in X-ray diffraction. Since the soft magnetic powder has a higher imaginary part magnetic permeability compared to the conventional magnetic powder, higher ability to suppress the noise can be obtained compared to the conventional magnetic powder.

Patent Literature 3 (Japanese Patent Laid-Open No. 2005-123531) discloses an alloy powder for use in electromagnetic wave absorbers which is obtained by flattening-processing a raw material powder having an oxygen concentration from 0.001 to 0.08% by mass before the flattening-processing to a powder having an aspect ratio of 10 or more and an average particle size from 20 to 50 µm. This powder for use in electromagnetic wave absorbers is described to be excellent in electromagnetic wave absorbing characteristics. Furthermore, Patent Literature 4 (Japanese Patent Laid-Open No. 2010-196123) describes a method for producing a flat soft magnetic powder including a powder providing step of providing a soft magnetic powder to be a raw material, a first heat-treating step of heat-treating the soft magnetic powder provided in the powder providing step, a flattening-processing step of flattening-processing the soft magnetic powder heat-treated in the first heat-treating step, and a second heat-treating step of heat-treating the soft magnetic powder flattened in the flattening-processing step. According to the above producing method, a flat soft magnetic powder having a high magnetic permeability is described to be obtained.

On the other hand, Patent Literature 5 (WO2007/013436 presents a soft magnetic material which has been formed by dispersing at least a flat soft magnetic powder in a crosslinked polyester-based resin. This soft magnetic material is described to have a high specific gravity, to exhibit good magnetic characteristics, and to exhibit small dimension change even under an environment at an elevated temperature or at an elevated temperature and high humidity. Patent Literature 6 (Japanese Patent Laid-Open No. 2005-142241) describes a ferrite-plated sendust fine particle in which the surface of a sendust fine particle is uniformly coated with a ferrite-plated layer and molded body thereof. It is stated that the ferrite-plated sendust fine particle and a molded body thereof allow a significant increase in the high frequency magnetic permeability and heightening the ferromagnetic resonance frequency simultaneously.
Patent Literature 7 relates to a specific composite magnetic body, a specific method of manufacturing the same, a specific circuit board using the same and a specific electronic apparatus using the same.

Among these, those obtained by flattening the magnetic metallic powders have a high magnetic permeability as described above and have been widely used in noise-suppressing application, but on the other hand, such materials have extremely high electric conductivity and readily cause heat generation at a high frequency as represented by eddy-current loss. In addition, since the magnetic permeability tends to be reduced on the high frequency side, the metallic powders by themselves do not necessarily allow noise suppression over all the frequency bands.

While powders having a high dielectric constant have high insulation, such powders are not suitable for noise-suppressing application for absorbing electromagnetic waves of a low frequency band because the frequencies at which absorption of electromagnetic waves occurs are biased to the relatively higher frequency side.

A metallic powder and a high dielectric have been also proposed to be used for a noise suppressor through mixing the both and molding the obtained mixture, but the content of the magnetic powder is required to be increased in order to be used for a noise suppressor since the magnetic permeability is necessary to be larger as a noise suppressor. On the other hand, an increased content of the magnetic powder results in large heat generation due to the dielectric constant loss as described above, and therefore a noise suppressor capable of simultaneously suppressing the noise and the heat generation is difficult to be produced.

Thus, each Patent Literature described above is intended to attain high magnetic permeability and there have been obtained no magnetic powders for noise suppression which hardly generate heat due to suppressing the dielectric constant loss.

### [Citation List]

### [Patent Literature]

[Patent Literature 1]
   Japanese Patent Laid-Open No. 2003-332113
[Patent Literature 2]
   Japanese Patent Laid-Open No. 2005-281783
[Patent Literature 3]
   Japanese Patent Laid-Open No. 2005-123531
[Patent Literature 4]
   Japanese Patent Laid-Open No. 2010-196123
[Patent Literature 5]
   WO2007/013436
[Patent Literature 6]
   Japanese Patent Laid-Open No. 2005-142241
[Patent Literature 7]
   US 2010/000769 A1

### [Summary of Invention]

### [Technical Problem]

Accordingly, the object of the present invention is to provide a composite magnetic powder for noise suppression capable of leading to a noise suppressor which has ability to suppress the noise in a wide range from a low frequency through a high frequency, while suppressing heat generation by reducing dielectric constant loss on the high frequency side.

### [Solution to Problem]

The present inventors have found the followings as a result of investigation. First, a magnetic material using a metallic powder has a large magnetic permeability at a relatively low frequency and a value thereof becomes smaller at a high frequency, thereby functioning as a low-pass filter, and a high dielectric (fine particle having a high dielectric constant) resonates at a frequency in a specific range in a relatively high frequency region, thereby functioning as a band-pass filter. In order to allow the metallic powder and the fine particle having a high dielectric constant to be used as a magnetic powder for use in noise suppressor while making good use of each ability of the metallic powder and the fine particle having a high dielectric constant as a filter, there may be used a powder which is produced by, not mixing the metallic powder and the fine particle having a high dielectric constant, but coating the surface of the metallic powder with the fine particle having a high dielectric constant in advance so as not to generate electric conductivity upon mutual contact of the particles. The present invention has been accomplished based on these findings.

That is, the present invention provides a composite magnetic powder for noise suppression in which a metallic powder is coated with a fine particle having a high dielectric constant and a binder resin,
wherein the metallic powder is selected from an iron powder, an Fe-Si alloy powder or an Ve-Si-Al alloy powder,
wherein the fine particle having a high dielectric constant is selected from CaTiO₃ or SrTiO₃, and wherein the binder resin is a poly(methyl methacrylate) resin or a styrene-acrylate copolymer.

### [Advantageous Effect of Invention]

The composite magnetic powder for noise suppression according to the present invention exhibits a small dielectric constant loss on the high frequency side. Therefore, a noise suppressor using this composite magnetic powder for noise suppression has ability to suppress the noise in a wide range from a low frequency through a high frequency, while suppressing heat generation at a high frequency.

### [Description of Embodiment]

Hereinafter, description will be made for an embodiment according to the present invention.

### <Composite magnetic powder for noise suppression according to the present invention>

The composite magnetic powder for noise suppression according to the present invention is formed by coating a metallic powder with a fine particle having a high dielectric constant and a binder resin.

As the metallic powder used herein, an iron powder, an Fe-Si alloy powder, an Ve-Si-Al alloy (sendust) powder is used. The form, the volume average particle size and the like of the metallic powders are not particularly limited.

According to the invention, the fine particle having a high dielectric constant is selected from CaTiO₃ or SrTiO₃. In addition, herein disclosed is that the fine particle having a high dielectric constant used in the composite magnetic powder for noise suppression may be selected from TiO₂, CaTiO₃, SrTiO₃ or a ferrite. The ferrite includes Mn-Mg-Sr ferrite, Mn-Zn ferrite, Cu-Zn ferrite, Ni-Zn ferrite, Ni-Zn-Cu ferrite and the like, and these are preferably used based on combinations of frequency characteristics of the dielectric constant and the magnetic permeability of each material.

For the binder resin used in the composite magnetic powder for noise suppression according to the present invention, a poly(methyl methacrylate) resin or a styrene-acrylate copolymer is used.

In the composite magnetic powder for noise suppression according to the present invention, the coating proportion of the fine particle having a high dielectric constant with respect to the metallic powder is desirably such that the metallic powder accounts for from 50 to 98% by weight and the fine particle having a high dielectric constant accounts for from 2 to 50% by weight. The coating proportion of the binder resin is desirably from 1 to 10 parts by weight per 100 parts by weight of total of the metallic powder and the fine particle having a high dielectric constant. When the metallic powder accounts for less than 50% by weight or the fine particle having a high dielectric constant accounts for more than 50%, the magnetic permeability decreases and the electromagnetic waves cannot be sufficiently absorbed on the low frequency side due to the relatively decreased magnetic material content, thereby making the ability to suppress the noise insufficient. When the metallic powder accounts for more than 98% by weight or the fine particle having a high dielectric constant accounts for less than 2%, the electromagnetic waves cannot be sufficiently absorbed on the high frequency side due to the relatively decreased high dielectric content, thereby making the ability to suppress the noise insufficient.

When the coating proportion of the binder resin per 100 parts by weight of total of the metallic powder and the fine particle having a high dielectric constant is less than 1 part by weight, the fine particle having a high dielectric constant cannot be sufficiently stuck to the surface of the metallic powder though depending on the diameter of the fine particle having a high dielectric constant. When the coating proportion of the binder resin exceeds 10 parts by weight, the binder resin is excessively present, the coated magnetic material particles agglomerate with each other, the agglomerate particles stick out from the surface of the electromagnetic wave absorber when the absorber is molded, and thus a desired shape or smoothness may not be obtained in some cases.

The thickness d of the resin coating layer containing the fine particle having a high dielectric constant is preferably from 0.3 µm to 10 µm. When d is less than 0.3 µm, the effect of adding the fine particle having a high dielectric constant cannot be obtained, and therefore the dielectric constant loss increases on the high frequency side, thereby possibly increasing the heat generation in the noise suppressor upon use in the noise suppressor application. When d exceeds 10 µm, the fine particle having a high dielectric constant is substantially excessively present and the metallic powder volume relatively decreases, and therefore the magnetic permeability is lowered as the magnetic material and the ability to suppress the noise may not be attained in some cases.

### (Determination of thickness of resin coating layer containing fine particle having high dielectric constant)

Determination of the thickness of the resin coating layer containing the fine particle having a high dielectric constant is as follows. A resulting magnetic material was embedded in an epoxy-based resin and then a sample of the magnetic material for cross-sectional observation was prepared by using a polishing machine. The resulting sample for cross-sectional observation was subjected to gold evaporation, confirmation was performed in a visual field at a magnification of 500 × on an FE-SEM (SU-8020, Hitachi High-Technologies Corporation), and then element-mapping was carried out at the same magnification on an EDX (E-Max Evolution, Horiba, Ltd.) to give images of the resulting distribution states for Ti and Fe.

Regarding the obtained images, the perimeters for each particle were determined from the projected areas in a state where the inside of the particle was painted out using the images for each of the elements of Ti, Mn and Fe by an image processing software (Image-Pro^{(R)} Plus, Media Cybernetics, Inc.), and the equivalent circle diameters R_{Ti}, R_{Mn} and R_{Fe} were calculated. Then, when the fine particle having a high dielectric constant was a titanate compound or a titanium oxide, the thickness of the resin coating layer for the particle measured in the n-th measurement was expressed as dₙ = (R_{nTi} - R_{nFe})/2, and when the fine particle having a high dielectric constant was a ferrite containing Mn, the thickness of the resin coating layer for the particle measured in the n-th measurement was made dₙ = (R_{nMn} - R_{nFe})/2. The element mapping by the EDX was repeatedly performed while changing the visual fields so as to allow the calculation of Rₙs for 100 particles, followed by the image analysis, and then the average value of the individual dₙs was made the thickness of the resin coating layer d.

Desirably, the volume resistivity of the composite magnetic powder for noise suppression according to the present invention at an electric field of 500 V/cm is 1 × 10⁸ Ω·cm or more, and more desirably 1 × 10⁹ Ω·cm or more. When the volume resistivity of the composite magnetic powder for noise suppression at an electric field of 500 V/cm is less than 1 × 10⁸ Ω·cm, the volume resistivity value means that the metallic magnetic materials would be in contact with each other when the noise suppressor is molded, and therefore the dielectric constant loss may be increased on the high frequency side, thereby possibly increasing the heat generation in the noise suppressor upon use in the noise suppressor application.

A dielectric constant loss, as used herein, represents a magnitude of the dielectric loss (tan δ) upon determination of the dielectric constant of the magnetic powder and does not represent only a specific loss such as, a dielectric loss of a high dielectric, an eddy-current loss of a metallic powder or a hysteresis loss.

### [Volume resistivity]

The volume resistivity is determined as described below.

A cylinder made of a fluororesin having a cross section of 4 cm² was charged with a sample so that the height was 4 mm, electrodes were attached to the both edges, a weight of 1 kg was put thereon, and then the resistivity was measured. In the determination of the resistivity, a voltage at 200 V was applied on an insulation resistivity meter, 6517A (Keithley Instruments Inc.), and the resistivity was calculated from the current value after 10 second from the voltage application to be made the volume resistivity.

### <Method for producing composite magnetic powder for noise suppression according to the present invention>

Then, description will be made for the method for producing the composite magnetic powder for noise suppression according to the present invention.

The method for coating the metallic powder with the fine particle having a high dielectric constant and the binder resin is not particularly limited, and may be a known method, either a dry process or a wet process. When a dry process is employed, for example, individual ingredients are introduced into a sample mill and are stirred and mixed at a uniform rate. Then, the binder resin is cured. The curing may be carried out by either an external heating system or an internal heating system, for example, using a fixed or fluidized electric furnace, rotary electric furnace or a burner furnace, or by microwaves. When a UV-curing resin is used, a UV heater is used. The curing temperature varies depending on resins to be used, but a temperature equal to or higher than the melting point or the glass transition point of the resin is required, and for a thermosetting resin, a condensation-crosslinking resin or the like, the temperature is required to be raised to that at which curing sufficiently proceeds.

In this way, the composite magnetic powder for noise suppression according to the present invention is obtained. This composite magnetic powder for noise suppression may be used for a noise suppressor as it is, but may be subjected to flattening or the like as necessary, followed by being molded into a sheet form or being laminated with other component, and then used for a noise suppressor.

Hereinafter, the present invention will be specifically illustrated based on Examples and the like.

### [Examples]

### Example 1 (Reference)

An iron powder having an average particle size of 60 µm (metallic powder) was coated with TiO₂ having an average particle size of 0.12 µm (fine particle having a high dielectric constant) and a styrene-acrylate copolymer (binder resin). The coating proportion was 10 parts by weight of TiO₂ per 90 parts by weight of the iron powder, and the styrene-acrylate copolymer was used so that the 3 parts by weight of the styrene-acrylate copolymer was present per 100 parts by weight of the total of the iron powder and TiO₂.

The coating conditions were as follows. That is, the individual ingredients were introduced into a sample mill at the proportion described above and were stirred and mixed at 20000 rpm for 15 seconds to coat the iron powder with TiO₂ and the styrene-acrylate copolymer, followed by curing the resin at 250°C for 3 hours to prepare a composite magnetic powder for noise suppression.

### Example 2 (Reference)

A composite magnetic powder for noise suppression was prepared in the same manner as that in Example 1 except that the coating proportion was 20 parts by weight of TiO₂ per 80 parts by weight of the iron powder, and 5 parts by weight of the styrene-acrylate copolymer was used per 100 parts of the total of the iron powder and TiO₂

### Example 3

A composite magnetic powder for noise suppression was prepared in the same manner as that in Example 2 except for using SrTiO₃ having an average particle size of 1.25 µm as the fine particle having a high dielectric constant.

### Example 4

A composite magnetic powder for noise suppression was prepared in the same manner as that in Example 2 except for using CaTiO₃ having an average particle size of 1.45 µm as the fine particle having a high dielectric constant.

### Example 5 (Reference)

A composite magnetic powder for noise suppression was prepared in the same manner as that in Example 2 except for using Mn-Mg-Sr ferrite having an average particle size of 0.05 µm as the fine particle having a high dielectric constant.

### Example 6 (Reference)

A composite magnetic powder for noise suppression was prepared in the same manner as that in Example 2 except for using Fe-Si-Al alloy (sendust) having an average particle size of 120 µm as the metallic powder.

### Comparative Example 1

A composite magnetic powder for noise suppression was prepared in the same manner as that in Example 2 except that the iron powder was not coated with the fine particle having a high dielectric constant.

The individual ingredients (metallic powders, fine particles having a high dielectric constant and a binder resin) and the blending proportions thereof in Examples 1 to 6 and Comparative Example 1 are set forth in Table 1, and the conditions of coating the metallic powder with the fine particle having a high dielectric constant and the binder resin (processing conditions and resin-curing conditions) are set forth in Table 2. In addition, there are set forth in Table 3 the powder characteristics (average article diameters, apparent densities, true specific gravities and thicknesses of the coating layer of the resin containing the fine particle having a high dielectric constant), the magnetic characteristics (saturation magnetization, residual magnetization and coercivity) and the volume resistivity of the resulting composite magnetic powders for noise suppression, the complex magnetic permeabilities and the complex dielectric constants thereof are set forth in Table 4, and the losses of these complex magnetic permeability and complex dielectric constant are set forth in Table 5. The methods for determining the volume average particle sizes, the apparent densities and the true specific gravities set forth in Table 3 and the complex magnetic permeabilities, the complex dielectric constants and losses thereof set forth in Tables 4 and 5 as used herein are as follows. In addition, the methods for determining the thicknesses of the coating layer of the resin containing the fine particle having a high dielectric constant and the volume resistivitys are as described above.

### (Volume average particle size)

The volume average particle sizes were determined by a laser diffraction scattering method. A microtrac particle size analyzer (Model 9320-X100, Nikkiso Co., Ltd.) was used as the apparatus. The refractive index was set to 2.42 and the determination was performed under an environment of 25 ± 5°C and humidity of 55 ± 15%. The volume average particle size (median diameter), as used herein, refers to a particle diameter at the cumulative 50% as expressed by under screen in the volume distribution mode. Water was used as the dispersion medium.

### (Apparent density)

The apparent densities were determined according to the JIS Z 2504. The details are as follows.

### 1. Apparatus

As an apparatus for powder apparent density determination, one composed of a funnel, a cup, a funnel support, a supporting rod and a supporting stand is used. As a balance, one having a reciprocal sensibility of 50 mg at a maximum weight of 200 g is used.

### 2. Procedures

(1) A sample at least 150 g is used.
(2) The sample is poured into a funnel having an orifice of 2.5^{+0.2/-0} mm bore diameter until the cup is filled with the sample flowing out from the funnel and the sample spills over.
(3) When the sample starts spilling over, pouring the sample is immediately stopped and the raised sample above the cup is scraped off with a spatula along the upper edge of the cup to be leveled, while not giving vibration to the sample.
(4) The cup is tapped on the side wall to settle the sample and remove the sample attached to the outside of the cup, and then the weight of the sample is weighed with accuracy of 0.05 g.

### 3. Calculation

A value obtained by multiplying the measured value obtained in the preceding item 2-(4) by 0.04 is rounded to the second decimal place according to the JIS Z 8401 (Rules for Rounding off of Numerical Values) and the rounded value is made the apparent density in a unit of "g/cm³."

### (True specific gravity)

The true specific gravities were determined using a pycnometer according to the JIS R 9301-2-1. In this case, methanol was used as a solvent and determination was carried out at 25°C.

### (Magnetic characteristics)

The magnetic characteristics was determined using a vibrating sample magnetometer (model: VSM-C7-10A, Toei Industry Co., Ltd.). A cell having an inner diameter of 5 mm and a height of 2 mm was filled with a sample for determination (composite magnetic powder), and then was mounted on the magnetometer. The determination was carried out by providing an applied magnetic field and the applied magnetic field was swept up to 1 K·1000/4π·A/m. Subsequently, while the applied magnetic field was being lowered, the hysteresis curve was drawn on the recording paper. The magnetization, the residual magnetization and the coercivity in an applied magnetic field of 1 K·1000/4π·A/m were read from the curve data.

### (Determination of complex dielectric constant and complex magnetic permeability)

Determination of the complex dielectric constants and the complex magnetic permeabilities were carried out in the following manner. The determination was carried out using an E4991A type RF impedance/material analyzer, a 16453A dielectric measuring electrode and a 16454A magnetic material measuring electrode (Agilent Technologies).

The preparation procedures for the sample for determination of the complex dielectric constant is as follows. That is, 9.7 g of the composite magnetic powder for noise suppression and 0.3 g of a binder resin (Kynar 301F: polyvinylidene fluoride) are weighed, introduced into a 50 cc glass bottle, and then stirred and mixed on a ball mill (100 rpm) for 30 minutes.

After completion of the stirring, approximately 1.2 g of the mixed material is weighed and introduced into a die having a diameter of 13 mm, followed by being pressurized on a press machine under a pressure of 40 MPa for 3 minutes. The resulting molded body was allowed to stand in an air forced oven at 140°C for 2 hours and used as the sample for complex dielectric constant determination. The sample for complex magnetic permeability determination was prepared by molding the molded body in the same manner as that for the sample for complex dielectric constant determination, followed by boring a hole of 4.5 mm in the central part. The diameter, the thickness and the inner diameter of the sample molded body for measurement are measured and input into the measuring apparatus in advance. In the determination, the amplitude was set to 10 mA, sweeping was carried out in a logarithmic scale in the range from 1 MHz to 1 GHz, and the complex magnetic permeability (real part magnetic permeability µ' and imaginary part magnetic permeability µ"), the complex dielectric constant (real part magnetic dielectric constant ε' and imaginary part dielectric constant ε''), and the magnetic permeability loss and the dielectric constant loss (tan δ) were measured.

Desirably, the dielectric constant loss of the composite magnetic powder for noise suppression according to the present invention is 0.11 or less at 1 MHz to 100 MHz. When the dielectric constant loss of the composite magnetic powder for noise suppression is more than 0.11 at 1 MHz-100 MHz, the dielectric constant loss of the noise suppressor which is molded becomes larger, and therefore the noise suppressor may possibly cause large heat generation upon use in the noise suppressor application.

Desirably, the dielectric constant loss of the composite magnetic powder for noise suppression according to the present invention is 0.22 or less at 1 GHz. When the dielectric constant loss of the composite magnetic powder for noise suppression is more than 0.22 at 1 GHz, the dielectric constant loss of the noise suppressor which is molded becomes larger, and therefore the noise suppressor may possibly cause large heat generation upon use in the noise suppressor application.

**[Table 1]**

| | Metallic powder | | | | Fine particle having high dielectric constant | | | Binder resin | |
|---|---|---|---|---|---|---|---|---|---|
| | Composition | Form | Average particle size (µm) | Part by weight | Composition | Average particle size (µm) | Part by weight | Composition | Part by weight * |
| Example 1 | Iron powder | Granular | 60 | 90 | TiO₂ | 0.12 | 10 | Styrene-acrylate copolymer | 3 |
| Example 2 | Iron powder | Granular | 60 | 80 | TiO₂ | 0.12 | 20 | Styrene-acrylate copolymer | 5 |
| Examples 3 | Iron powder | Granular | 60 | 80 | SrTiO₃ | 1.25 | 20 | Styrene-acrylate copolymer | 5 |
| Example 4 | Iron powder | Granular | 60 | 80 | CaTiO₃ | 1.45 | 20 | Styrene-acrylate copolymer | 5 |
| Example 5 | Iron powder | Granular | 60 | 80 | Mn-Mg-Sr Ferrite | 0.05 | 20 | Styrene-acrylate copolymer | 5 |
| Example 6 | Sendust | Perfectly-spherical | 120 | 80 | TiO₂ | 0.12 | 20 | Styrene-acrylate copolymer | 5 |
| Comparative Example 1 | Iron powder | Granular | 60 | 80 | None | None | None | Styrene-acrylate copolymer | 5 |

| | | | | | | | | | |
|---|---|---|---|---|---|---|---|---|---|
| * Ratio by weight of the binder resin (powder) to the metallic powder + the fine particle having high dielectric constant | | | | | | | | | |

**[Table 2]**

| | Coating conditions | | | | |
|---|---|---|---|---|---|
| | Processing conditions | | | Resin-curing conditions | |
| | Apparatus | Rotational Frequency (rpm) | Time (sec) | Temperature (°C) | Time (hr) |
| Example 1 | Sample mill | 20000 | 15 | 250 | 3 |
| Example 2 | Sample mill | 20000 | 15 | 250 | 3 |
| Example 3 | Sample mill | 20000 | 15 | 250 | 3 |
| Example 4 | Sample mill | 20000 | 15 | 250 | 3 |
| Example 5 | Sample mill | 20000 | 15 | 250 | 3 |
| Example 6 | Sample mill | 20000 | 15 | 250 | 3 |
| Comparative Example 1 | Sample mill | 20000 | 15 | 250 | 3 |

**[Table 3]**

| | Powder characteristics | | | | Magnetic characteristics at 1 K·1000/4π·A/m (VSM) | | | Volume resistivity (Ω·cm) |
|---|---|---|---|---|---|---|---|---|
| | Volume average particle size (µm) | Apparent density (g/cm³) | True specific gravity | Thickness of resin coating layer containing fine particle having high dielectric constant (µm) | Magnetization (Am²/kg) | Residual magnetization (Am²/kg) | Coercivity (A/m) | |
| Example 1 | 63.79 | 2.02 | 6.81 | 2.8 | 53.86 | 0.80 | 17.22 | 6.59×10¹³ |
| Example 2 | 66.2 | 2.30 | 6.74 | 4.2 | 55.22 | 0.85 | 17.7 | 6.88×10¹³ |
| Example 3 | 63.35 | 2.26 | 6.53 | 1.8 | 47.20 | 0.71 | 17.44 | 7.27×10¹³ |
| Example 4 | 63.71 | 2.02 | 6.21 | 2.1 | 47.46 | 0.71 | 17.37 | 6.42×10¹³ |
| Example 5 | 69.66 | 2.11 | 6.58 | 6.3 | 58.00 | 2.19 | 31.49 | 2.97×10⁹ |
| Example 6 | 125.26 | 2.00 | 5.29 | 5.8 | 42.33 | 0.49 | 14.11 | 5.64×10¹³ |
| Comparative Example 1 | 61.11 | 2.65 | 6.93 | - | 58.33 | 0.73 | 16.97 | Too low to measure |

**[Table 4]**

| | Complex magnetic permeability | | | | | | | | Complex dielectric constant | | | | | | | |
|---|---|---|---|---|---|---|---|---|---|---|---|---|---|---|---|---|
| | 1 MHz | | 10 MHz | | 100 MHz | | 1 GHz | | 1 MHz | | 10 MHz | | 100 MHz | | 1 GHz | |
| | µ' | µ" | µ' | µ" | µ' | µ" | µ' | µ" | ε' | ε" | ε' | ε" | ε' | ε" | ε' | ε" |
| Example 1 | 13.8 | 2 | 9.5 | 3.2 | 4.1 | 3 | 1.3 | 1.6 | 55.3 | 0.1 | 42.1 | 2.7 | 39 | 1.7 | 36.1 | 6.3 |
| Example 2 | 8.9 | 0.2 | 6.8 | 1.8 | 3.6 | 1.9 | 1.4 | 1.3 | 32.1 | <0.1 | 25.8 | 1.1 | 24.6 | 0.8 | 24.7 | 3.3 |
| Example 3 | 8.7 | 0.1 | 6.6 | 1.7 | 3.4 | 2 | 1.3 | 1.3 | 44 | <0.1 | 35.1 | 1.6 | 33.2 | 1.2 | 34.5 | 4.3 |
| Example 4 | 8.3 | <0.1 | 6.4 | 1.6 | 3.3 | 1.8 | 1.2 | 1.2 | 33.7 | <0.1 | 27.2 | 1.3 | 25.8 | 0.8 | 26.8 | 3.2 |
| Example 5 | 17.6 | 2.7 | 11.6 | 4.4 | 5.2 | 3.3 | 1.8 | 2.5 | 28.1 | 0.6 | 20.2 | 1.7 | 18.5 | 0.8 | 19 | 2.5 |
| Example 6 | 6.1 | 0.4 | 5.2 | 0.7 | 3.2 | 1.5 | 0.6 | 1.2 | 24.1 | <0.1 | 20.3 | 0.4 | 20 | 0.4 | 20.7 | 0.2 |
| Comparative Example 1 | 16.9 | 1.2 | 11.8 | 4.2 | 4.8 | 3.8 | 0.9 | 1.8 | 65.1 | 12.2 | 54.1 | 10.5 | 43.7 | 5.1 | 41.6 | 9.9 |

**[Table 5]**

| | Loss | | | | | | | |
|---|---|---|---|---|---|---|---|---|
| | tan δ of magnetic permeability | | | | tan δ of dielectric constant | | | |
| | 1 MHz | 10 MHz | 100 MHz | 1 GHz | 1 MHz | 10 MHz | 100 MHz | 1 GHz |
| Example 1 | 0.145 | 0.337 | 0.732 | 1.231 | 0.002 | 0.064 | 0.044 | 0.175 |
| Example 2 | 0.022 | 0.265 | 0.528 | 0.929 | 0.000 | 0.043 | 0.033 | 0.134 |
| Example 3 | 0.011 | 0.258 | 0.588 | 1.000 | 0.000 | 0.046 | 0.036 | 0.125 |
| Example 4 | 0.000 | 0.250 | 0.545 | 1.000 | 0.000 | 0.048 | 0.031 | 0.119 |
| Example 5 | 0.153 | 0.379 | 0.635 | 1.389 | 0.021 | 0.084 | 0.043 | 0.132 |
| Example 6 | 0.066 | 0.135 | 0.469 | 2.000 | 0.000 | 0.020 | 0.020 | 0.010 |
| Comparative Example 1 | 0.071 | 0.356 | 0.792 | 2.000 | 0.187 | 0.194 | 0.117 | 0.238 |

The composite magnetic powders for noise suppression of Examples 1 to 6 exhibit small dielectric constant losses at a high frequency. On the other hand, the composite magnetic powder of Comparative Examples 1 not only has a too low resistivity to be determined but also exhibits a large dielectric constant loss on the high frequency due to absence of the coating with the fine powder having a high dielectric constant, and thus was a magnetic powder which is likely to cause heat generation in spite of having ability to suppress the noise in the wide range from a low frequency through a high frequency.

### [Industrial Applicability]

Since the composite magnetic powder for noise suppression according to the present invention exhibits a small dielectric constant loss on the high frequency side, there can be obtained a noise suppressor having ability to suppress the noise in the wide range from a low frequency through a high frequency while suppressing heat generation. This noise suppressor can be suitably used for noise suppression in digital electronic equipment such as personal computers and cellular phones.

## Claims

1. A composite magnetic powder for electromagnetic noise suppression, wherein a metallic powder is coated with a fine particle having a high dielectric constant and a binder resin,
wherein the metallic powder is selected from an iron powder, an Fe-Si alloy powder or an Ve-Si-Al alloy powder,
wherein the fine particle having a high dielectric constant is selected from CaTiO₃ or SrTiO₃, and
wherein the binder resin is a poly(methyl methacrylate) resin or a styrene-acrylate copolymer.

## Patentansprüche

1. Ein Kompositmagnetpulver zur elektromagnetischen Geräuschunterdrückung, wobei ein Metallpulver mit einem feinen Teilchen, das eine hohe dielektrische Konstante und ein Bindemittelharz aufweist, überzogen ist,
wobei das Metallpulver aus einem Eisenpulver, einem Fe-Si-Legierungspulver oder einem Fe-Si-Al-Legierungspulver ausgewählt ist,
wobei das feine Teilchen, das eine hohe dielektrische Konstante aufweist, aus CaTiO₃ oder SrTiO₃ ausgewählt ist, und
wobei das Bindemittelharz ein Poly(methylmethacrylat)harz oder ein Styrol-Acrylatcopolymer ist.

## Revendications

1. Poudre magnétique composite pour suppression du bruit électromagnétique, dans laquelle une poudre métallique est revêtue de fines particules ayant une constante diélectrique élevée et d'une résine liante,
dans laquelle la poudre métallique est choisie parmi une poudre de fer, une poudre d'alliage de Fe-Si et une poudre d'alliage de Fe-Si-Al,
dans laquelle les fines particules ayant une constante diélectrique élevée sont choisies parmi CaTiO₃ ou SrTiO₃, et
dans laquelle la résine liante est une résine de poly(méthacrylate de méthyle) ou un copolymère de styrène-acrylate.
